# EUROPEAN PATENT SPECIFICATION

(11) **EP 3 169 146 B1**
(45) Date of publication and mention of the grant of the patent: **31.10.2018**
(21) Application number: 14897258.1
(22) Date of filing: 10.07.2014
(51) Int. Cl.: H05K 13/04, H05K 13/08, G06T 7/00, G06F 17/50, G06T 7/73

(54) **METHOD FOR PRODUCING COMPONENT PLACEMENT COORDINATES AND DEVICE FOR PRODUCING COMPONENT PLACEMENT COORDINATES**
VERFAHREN ZUR ERZEUGUNG VON KOMPONENTENPLATZIERUNGSKOORDINATEN UND VORRICHTUNG ZUR ERZEUGUNG VON KOMPONENTENPLATZIERUNGSKOORDINATEN
PROCÉDÉ DE PRODUCTION DE COORDONNÉES DE PLACEMENT DE COMPOSANTS ET DISPOSITIF DE PRODUCTION DE COORDONNÉES DE PLACEMENT DE COMPOSANTS

(43) Date of publication of application: 17.05.2017
(73) Proprietor: FUJI Corporation, Chiryu Aichi (JP)
(72) Inventor: NAKAJIMA Mikio, Chiryu-shi Aichi 472-8686 (JP); OIKE Hiroshi, Chiryu-shi Aichi 472-8686 (JP); ESAKI Hirotake, Chiryu-shi Aichi 472-8686 (JP); SUGIYAMA Kenji, Chiryu-shi Aichi 472-8686 (JP)
(74) Representative: Grünecker Patent- und Rechtsanwälte PartG mbB
(86) International application number: PCT/JP2014/068422
(87) International publication number: WO 2016/006076

(56) References cited:
- JP-A- H0 689 341
- JP-A- 2004 151 057
- JP-A- 2006 179 756
- JP-A- 2006 179 756
- JP-A- 2012 069 617
- JP-A- 2012 069 617
- JP-U- H02 122 470
- Mvtec Software Gmbh: "Building Vision for Business MVTec Software GmbH Solution Guide I Basics", , 30 November 2011 (2011-11-30), pages 1-307, XP055356590, internet Retrieved from the Internet: URL:http://download.mvtec.com/halcon-10.0- solution-guide-i.pdf [retrieved on 2017-03-20]

## Description

### Technical Field

The present invention relates to a creation method and a creation device of component mounting coordinates which automatically create coordinate data of mounting positions of a plurality of components to be mounted onto a circuit board.

### Background Art

A component mounting machine sequentially mounts the plurality of components onto the circuit board. Generally, since the mounting operation of the component mounting machine is controlled by a computer, it is necessary to create a mounting sequence in advance. The mounting sequence is generally formed of data such as the types of components to be mounted, the mounting order, the position at which the components are supplied, the mounting positions on the circuit board, and the types of nozzle to be used in the mounting. Among these, the mounting positions on the circuit board are represented using coordinate data of a two-dimensional Cartesian coordinate system in which a specific position on the circuit board is used as an origin point. The applicant of the present application discloses, in PTL 1, an example of a device which automatically creates coordinate data of mounting positions.

A component mounting coordinates creation device disclosed in PTL 1 is provided with means for searching a mounting position of each component by performing pattern matching in which pad information of Gerber data is compared with terminal information of part data of each component, and means for calculating coordinate data of the mounting position of each component based on the pattern matching results. Furthermore, the order of searching which improves the accuracy of the pattern matching is disclosed with a focus on the structural characteristics of various components. Accordingly, it is possible to automatically create the coordinate data of the mounting positions of the components while greatly reducing the labor of the operator.

An electronic component mounting device of PTL 2 is provided with a camera which images a wiring pattern of a printed circuit board and component information, and an image processing device which processes the images which are captured by the camera to recognize a character pattern and a pad pattern on the printed board, recognizes pad coordinates in the vicinity of the character pattern, and uses the recognized pad coordinates to determine an attachment position and an attachment angle of an electronic component. Accordingly, since the type, the mounting position, and the mounting posture of electronic component to be mounted are recognized, the labor of the operator inputting mounting procedure NC data from a keyboard is saved.

### Citation List

### Patent Literature

PTL 1: JP-A-2012-69617
PTL 2: JP-A-2-184100

JP 2006 179756 A describes a substrate inspection method that carries out alignment based on component mounting information and the substrate design information. Component representative coordinates of all components are computed from location information of respective components obtained from the substrate design information or the component mounting information, respective land regions obtained from the substrate design information are extracted, location information about the land regions is acquired to compute representative coordinates of all lands, offsets are computed which are differences between the component representative coordinates and the land representative coordinates, and the pertinent component representative coordinates and the land representative coordinates are made to coincide with each other based on the pertinent offsets to align the components.

JP 2012 069617 A relates to a component attachment coordinate generating device and component attachment coordinate generating method. The coordinate data for attachment position of components is calculated by searching the attachment position of the components on a circuit board, by performing pattern matching for searching a form/array pattern of the pads of the circuit board that matches with the form/array pattern of terminals of the components, by using the pad information of gerber data that is used when generating a print mask for printing a solder on the pad of the circuit board as the pad information for the circuit board, which is then compared with the terminal information of part data of the components.

### Technical Problem

By the way, in the technology of PTL 1, the pad information is compared to the terminal information; however, reliability is reduced in a case in which there are a plurality of component types which have different characteristic values in which the shape and the size are similar. For example, consideration is given to a case in which there are two types of chip resistor of similar shape and size which have resistance values of 10 W and 50 W. In this case, two items of a pair of pads information of the same arrangement on the circuit board are present. Therefore, a problem arises in which the mounting coordinates of the two types of chip resistor are mistaken between the two locations. In order to solve this problem, labor in which the operator selects the correct mounting coordinates becomes necessary, and additionally, much time is required for the creation of the coordinate data.

In the technology of PTL 1 and PTL 2, both perform pattern matching; however, the embodiment method thereof is not disclosed, and problems in accuracy are conceivable. For example, although mistakes in the connection itself are annulled if the pad information matches the terminal information, suitable coordinate data can not always be obtained. In other words, since the pads are ordinarily formed large in comparison to the size of the terminals, even if there is error in the coordinate data and the positions of the terminals are slightly shifted, it is possible to perform soldering onto the pads. However, it is important to position the terminals in the center of the pads from a reliability perspective, and a specific method of realizing the positioning is not disclosed in PTL 1 or 2.

Since multiple character patterns are lined up when the component arrangement on the circuit board becomes crowded, the delimitation of the plurality of character patterns which are displayed adjacently becomes unclear, and a concern arises that correct recognition may not be performed. Additionally, when the component arrangement becomes crowded, a concern arises that the correspondence between the character patterns and the pad patterns will be mistaken.

The present invention has been made in view of a problem of the background art, and an object thereof is to provide a creation method and a creation device of component mounting coordinates capable of accurately identifying pads corresponding to components without relying on the combinations of a plurality of types of components or a magnitude of the number of components to be mounted onto a circuit board, in particular, even in a case in which there are a plurality of component types which have different characteristic values in which the shape and size are similar, and further, capable of reliably creating coordinate data of suitable mounting positions.
It is the object of the present invention to provide a method and system for more accurately determining component mounting coordinates on a circuit board.
This object is solved by the subject matter of the independent claims.
Embodiments are defined by the dependent claims.

### Solution to Problem

An invention of the creation method of component mounting coordinates according to Claim 1 which solves the problem described above is a creation method of component mounting coordinates which automatically creates coordinate data of each mounting position of a plurality of components on a circuit board using a component table which associates component identification information with each item of which it is possible to identify each of the plurality of components to be mounted onto the circuit board, and component data names which are attached to component data of the plurality of components, in which the creation method acquires a pad arrangement image which represents the component identification information which is displayed on the circuit board, and dispositions of pads which are formed on the circuit board and to which connecting sections of the plurality of components are connected, and in which the creation method creates a component template image which represents dispositions of the connecting sections of a relevant component based on shape data of the relevant component which is included in the component data to which the component data name corresponding to the component identification information is attached, and matches the component template image to the pad disposition image in a vicinity of relevant component identification information to identify the pads to which the connecting sections of the relevant component are to be connected, and to further calculate the coordinate data of the relevant component on a premise of a state in which the connecting sections of the relevant component are caused to overlap the pads which are identified.
The invention of the creation device of the component mounting coordinates according to Claim 10 is a creation device of component mounting coordinates which automatically creates coordinate data of each mounting position of a plurality of components on a circuit board using a component table which associates component identification information with each item of which it is possible to identify each of the plurality of components to be mounted onto the circuit board, and component data names which are attached to component data of the plurality of components, the creation device including board information acquisition means for acquiring a pad arrangement image which represents the component identification information which is displayed on the circuit board, and dispositions of pads which are formed on the circuit board and to which connecting sections of the plurality of components are connected, and mounting coordinate calculation means for creating a component template image which represents dispositions of the connecting sections of a relevant component based on shape data of the relevant component which is included in the component data to which the component data name corresponding to the component identification information is attached, and matching the component template image to the pad disposition image in a vicinity of relevant component identification information to identify the pads to which the connecting sections of the relevant component are to be connected, and to further calculate the coordinate data of the relevant component on a premise of a state in which the connecting sections of the relevant component are caused to overlap the pads which are identified.

### Advantageous Effects of Invention

According to the invention of the creation method of component mounting coordinates according to Claim 1, for the relevant component which is identified by the component identification information which is displayed on the circuit board, the component template image which represents the arrangement of the connecting sections is created based on the shape data which is included in the component data to which the component data name corresponding to the relevant component identification information is attached, and the pads are identified by matching the component template image to the pad arrangement image in the vicinity of the relevant component identification information. In other words, when identifying the pads to which the connecting sections of the relevant component are to be connected, not only is the pattern matching of the geometric arrangement performed, but the correspondence between the component identification information and the component data name is also used. Therefore, even in a case in which a plurality of component types of the same size and shape with different characteristic values are present and there is a concern that the correspondence between the components and the pads will be mistaken with only the pattern matching, the mistake no longer occurs due to the component identification information which is displayed in the vicinity of the pads, and it is possible to accurately identify the pads which correspond to each component. In the matching between the component template image and the pad arrangement image, the coordinate data of the relevant component is calculated on the premise of a state in which the connecting sections of the relevant component are caused to overlap the pads which are identified. Therefore, it is possible to reliably create the coordinate data of the suitable mounting coordinates at which it is possible to favorably connect the connecting sections to the pads.
According to the invention of the creation device of component mounting coordinates according to Claim 10, it is possible to realize a device which performs the creation method of component mounting coordinates which is described in Claim 1. The effects of the invention of the device according to
Claim 10 are similar to the effects of the invention of the method according to Claim 1.

### Brief Description of Drawings

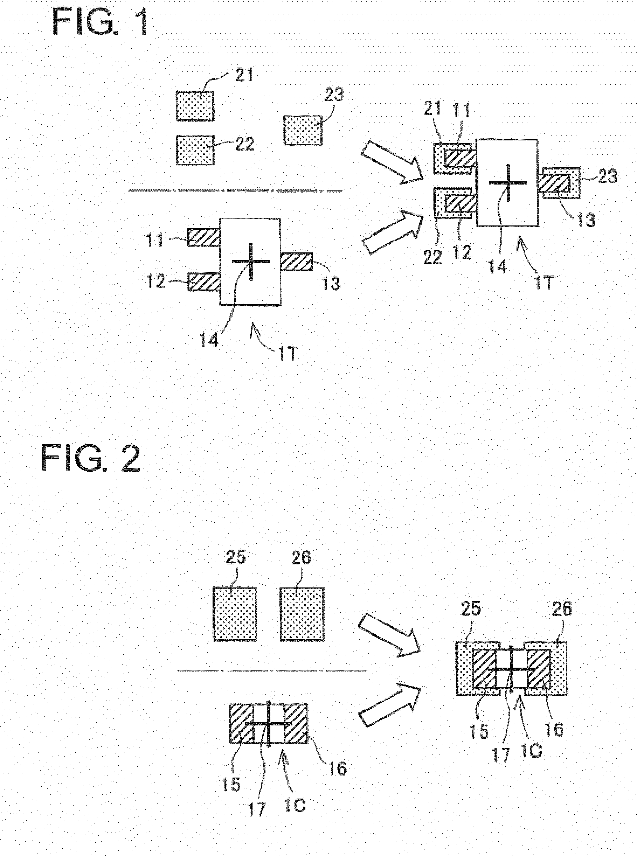

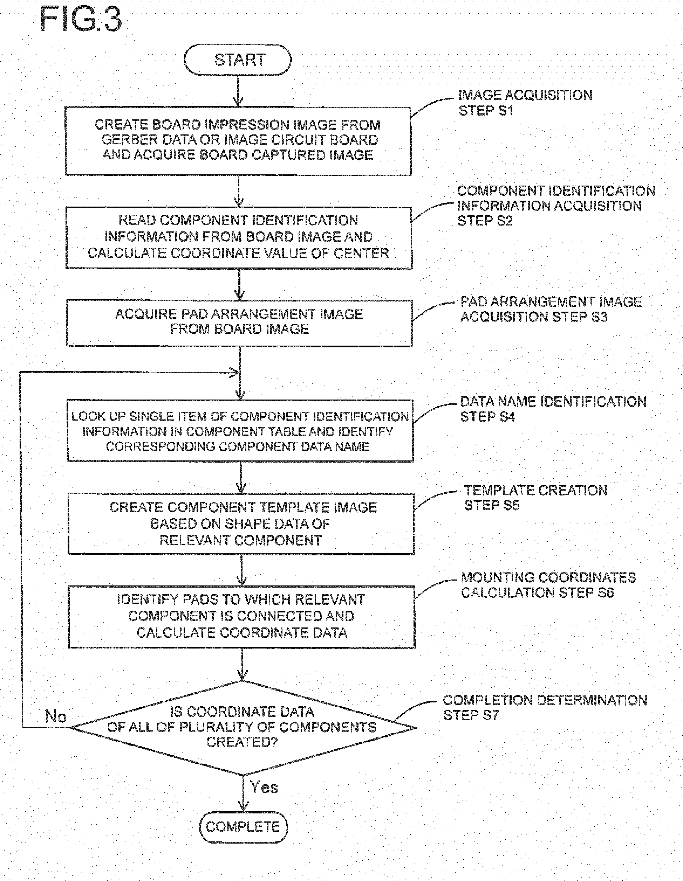

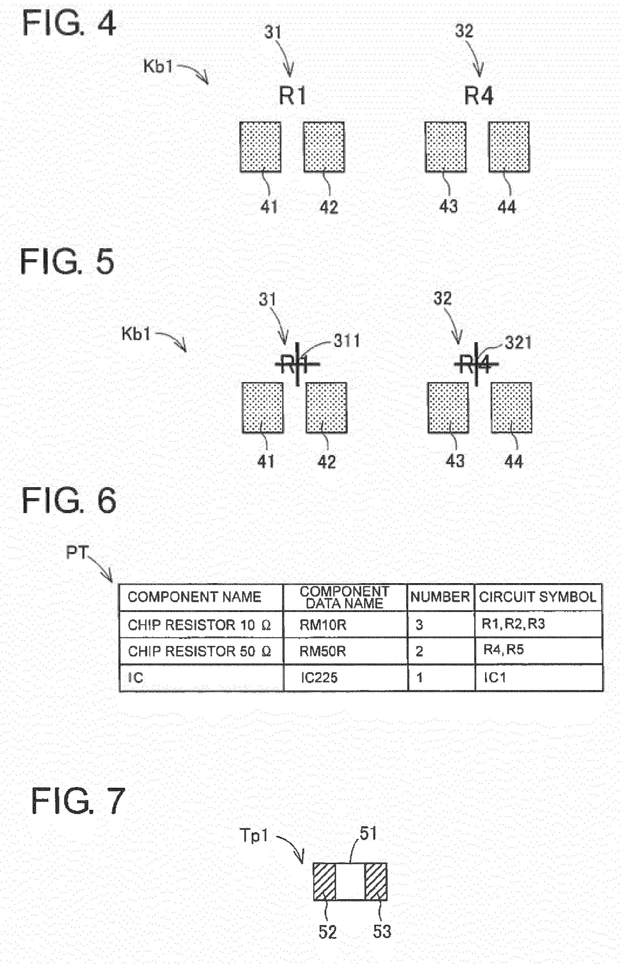

[Fig. 1] Fig. 1 is a diagram illustrating the basic concept of a creation method of component mounting coordinates, using a transistor component as an example;[Fig. 2] Fig. 2 is a diagram illustrating the basic concept of the creation method of component mounting coordinates, using a chip component as an example;[Fig. 3] Fig. 3 is a diagram of a flowchart of process operations of a creation device which performs the creation method of component mounting coordinates of an embodiment;[Fig. 4] Fig. 4 is a diagram illustrating a simple schematic example of a board image, and is illustrated with light and dark inverted in comparison to an actual circuit board;[Fig. 5] Fig. 5 is a diagram illustrating coordinate values of centers of circuit symbols which are examples of component identification information;[Fig. 6] Fig. 6 is a diagram exemplifying a component table which is used in the embodiment;[Fig. 7] Fig. 7 is a diagram exemplifying a component template image of a relevant component;
[Fig. 8] Fig. 8 is a diagram exemplifying matching results of matching the component template image to a pad arrangement image;
[Fig. 9] Fig. 9 is a diagram of a flowchart illustrating the process flow of optical character recognition;
[Fig. 10] Fig. 10 is a diagram of a board image exemplifying the process results of the process flow of the optical character recognition in a component identification information acquisition step;
[Fig. 11] Fig. 11 is a diagram illustrating a case in which a rotational direction of the component identification information which is displayed on the circuit board is changed at a pitch of 90°;
[Fig. 12] Fig. 12 is a diagram illustrating a method of determining the delimitation of character string information using a threshold distance;
[Fig. 13] Fig. 13 is a diagram illustrating the identification method of a partial match which is performed on the component identification information which is formed of the character string information;
[Fig. 14] Fig. 14 is a diagram schematically illustrating a case in which the positional relationship between the component template image of the transistor component and the pad arrangement image is suitable;
[Fig. 15] Fig. 15 is a diagram schematically illustrating a case in which the positional relationship between the component template image of the transistor component and the pad arrangement image is not suitable;
[Fig. 16] Fig. 16 is a diagram of the actual state of the component template image of the transistor component before carrying out a smoothing process;
[Fig. 17] Fig. 17 is a diagram of the actual state of the component template image of the transistor component after carrying out the smoothing process;
[Fig. 18] Fig. 18 is a diagram of the actual state of the pad arrangement image before carrying out the smoothing process;
[Fig. 19] Fig. 19 is a diagram of the actual state of the pad arrangement image after carrying out the smoothing process;
[Fig. 20] Fig. 20 is a diagram illustrating the method of a pattern matching process;
[Fig. 21] Fig. 21 is a diagram illustrating an example of the setting method of a mounting coordinate valid area; and
[Fig. 22] Fig. 22 is a diagram exemplifying the method of displaying the correspondence between the component identification information and the pads on the circuit board.

### Description of Embodiments

Description will be given of the creation method of component mounting coordinates of the embodiment of the present invention with reference to Figs. 1 to 22. First, exemplary description will be given of the basic concept of the creation method of component mounting coordinates. Fig. 1 is a diagram illustrating the basic concept of the creation method of component mounting coordinates, using a transistor component as an example. Fig. 2 is a diagram illustrating the basic concept of the creation method of component mounting coordinates, using a chip component as an example.

As illustrated in the top left of Fig. 1, pads 21 to 23, the three of which form a set, are provided on the surface of a circuit board. The three pads 21 to 23 are formed of a conductive material such as copper as one kind of an electronic circuit, and facilitate the mounting of terminals 11 to 13 of a transistor component 1T. In the example of Fig. 1, each of the three pads 21 to 23 is a rectangular shape, and the three pads 21 to 23 are positioned on three vertex positions of a narrow and long isosceles triangle. The shape, size, and arrangement position on the circuit board of each of the pads 21 to 23 is defined by a design of the circuit board, and is stored in the Gerber data.

Meanwhile, as illustrated in the bottom left of Fig. 1, the transistor component 1T includes the three terminals 11 to 13. The terminals 11 to 13 are connecting sections which are connected to the pads 21 to 23 by soldering. The shape of the bottom surface, to be soldered, of each of the terminals 11 to 13 is a rectangle which is a size smaller than each of the pads 21 to 23. In actuality, using the shape, size, and mutual arrangement of the terminals 11 to 13 of the transistor component 1T as a reference, the shape, size, and mutual arrangement of the pads 21 to 23 on the circuit board are designed in accordance. The mounting position when mounting the transistor component 1T onto the circuit board is represented by coordinate data of a center 14 (indicated using the intersection point of a thick cross which is displayed for convenience) of the transistor component 1T.

Here, as illustrated in the right of Fig. 1, the coordinate data of the center 14 of the transistor component 1T is created such that a state is assumed in which the terminals 11 to 13 overlap the centers of the corresponding pads 21 to 23, and this is the object of the creation method of component mounting coordinates. It is necessary to also specify the rotational posture of the transistor component 1T. In the creation of the coordinate data, the actual objects of the circuit board and the transistor component 1T are not necessary. In other words, instead of these, it is possible to create the coordinate data by using Gerber data of the circuit board and shape data of the transistor component 1T.

As illustrated in the top left of Fig. 2, pads 25 and 26, two of which form a set, are provided on the surface of the circuit board. The two pads 25 and 26 are formed of a conductive material such as copper as one kind of an electronic circuit, and facilitate the mounting of connecting sections 15 and 16 of a chip component 1C. In the example of Fig. 2, each of the two pads 25 and 26 is rectangular, and the pads 25 and 26 are disposed slightly separated. The shape, size, and arrangement position on the circuit board of each of the pads 25 and 26 is stored in the Gerber data.

As illustrated in the bottom left of Fig. 2, the chip component 1C includes the two rectangular connecting sections 15 and 16 on the bottom surface, and the connecting sections 15 and 16 are connected to the pads 25 and 26, respectively, by soldering. The mounting position when mounting the chip component 1C onto the circuit board is represented by coordinate data of a center 17 (indicated using the intersection point of a thick cross) of the chip component 1C. Here, as illustrated on the right side of Fig. 2, the coordinate data of the center 17 of the chip component 1C is created such that a state is assumed in which the connecting sections 15 and 16 overlap the centers of the corresponding pads 25 and 26, and this is the object of the creation method of component mounting coordinates. It is necessary to also specify the rotational posture of the chip component 1C. In a component such as a diode, which has polarity in the two connecting sections, it is necessary to specify the rotational posture so as not to invert the polarity.

The creation method of component mounting coordinates of the embodiment automatically creates the coordinate data of the mounting positions using all of the components to be mounted onto the circuit board as targets. The creation work is performed mainly by a computer operating as the creation device of component mounting coordinates of the embodiment (hereinafter shortened simply to the creation device) . In the delivery of the data and the like, the operation of the operator may partially intervene. Fig. 3 is a diagram of a flowchart of the process operations of the creation device which performs the creation method of component mounting coordinates of the embodiment. The creation method of component mounting coordinates of the embodiment includes an image acquisition step S1, a component identification information acquisition step S2, a pad arrangement image acquisition step S3, a data name identification step S4, a template creation step S5, a mounting coordinates calculation step S6, and a completion determination step S7.

Description will be given of the flow of the process operations of the creation device, with reference to Fig. 3. In the image acquisition step S1, the creation device creates a board impression image from the Gerber data, or images the circuit board to acquire a board captured image. In addition to data relating to the arrangement of the pads 21 to 23, 25, and 26 which are described earlier, the Gerber data includes various data which is necessary for the production of the circuit board, and includes component identification information. The component identification information is information which is displayed on the circuit board, and is information from which it is possible to specify each of the plurality of components which are to be mounted. Therefore, the creation device is capable of easily creating the board impression image which includes the component identification information of each of the plurality of components and the pad arrangement information. The creation device is capable of easily acquiring the board captured image using an imaging device such as a camera. The board captured image includes data relating to the component identification information and the arrangement of the pads.

Here, when the circuit board is close by, the creation device may adopt either of the board captured image and the board impression image. When the circuit board is not present, the creation device creates the board impression image. The board impression image is a virtual image, and the board captured image is an image based on the actual circuit board. However, both are equal in that they include data relating to the component identification information and the arrangement of the pads. Therefore, hereinafter, no distinction will be made between both, and both will simply be referred to as the board image.

In a case in which the board impression image is adopted, the influence of individual differences which arise in production and are present in the actual circuit board is not received. In a case in which the board captured image is adopted, even if, hypothetically, there are differences between the Gerber data and the actual circuit board, it is possible to use a board image which is matched to the actual circuit board. For example, even if there is hypothetically a production error in which pads which are slightly larger than the specification of the Gerber data are formed on the circuit board, if the board captured image which is obtained by imaging the actual pads is adopted, the influence of the production error is not received.

Fig. 4 is a diagram illustrating a simple schematic example of a board image Kb1, and is illustrated with light and dark inverted in comparison to an actual circuit board (the inversion of light and dark is the same in Figs. 5, 12, and 13). Two items of component identification information 31 and 32 which are depicted separated in the board image Kb1 are printed using a light colored ink such as white on the dark colored circuit board such as deep green. In the board image Kb1, an arrangement is depicted in which four pads 41 to 44 which are formed of a conductive material are lined up on the circuit board. Since multiple components are mounted on the actual circuit board, the number of items of component identification information and pads is greater than the board image Kb1 exemplified in Fig. 4.

In the component identification information acquisition step S2, the creation device reads each item of component identification information 31 and 32 from the board image Kb1. The component identification information includes character string information representing one of a component name, an abbreviation of the component name, a circuit symbol corresponding uniquely to the component name, the type of component, and a characteristic value of the component, and symbolic information representing the type of the component. For example, it is possible to exemplify "R" which represents a resistor component, or "C" which represents a capacitor component, or the like as an abbreviation of the component name, and it is possible to exemplify "1k" which represents the resistor component of 1 kw, "10p" which represents a capacitor component of 10 pF, or the like as the characteristic value of the component.

With relation to the board image Kb1 exemplified in Fig. 4, the creation device reads a circuit symbol "R1" as the component identification information 31 and a circuit symbol "R4" as the component identification information 32. The circuit symbol "R1" and the circuit symbol "R4" are character string information, and are uniquely defined as the component name and the component data name when looked up in a component table PT. As illustrated in Fig. 5, the creation device reads a coordinate value of a center 311 of the component identification information 31 (the circuit symbol "R1"), and the coordinate value of a center 321 of the component identification information 32 (the circuit symbol "R4") . Fig. 5 is a diagram illustrating coordinate values of the centers 311 and 312 of circuit symbols which are examples of the component identification information 31 and 32.

In the pad arrangement image acquisition step S3, the creation device extracts data relating to the arrangement of the pads from the data which forms the board image Kb1 to acquire a pad arrangement image Pd1. In other words, the creation device acquires the pad arrangement image which depicts the shape, size and arrangement position on the circuit board of the four pads 41 to 44. The creation device is capable of simplifying or deleting excess data which is unrelated to the arrangement of the pads 41 to 44 in the board image Kb1 to obtain the pad arrangement image Pd1. A board information acquisition step is formed of the sum of the three steps, the image acquisition step S1, the component identification information acquisition step S2, and the pad arrangement image acquisition step S3.

In the data name identification step S4, the creation device focuses on the first single item of the component identification information 31, looks this up in the component table PT, and identifies the component data name of the relevant component. Fig. 6 is a diagram exemplifying the component table PT which is used in the embodiment. The component table PT which is exemplified is represented by a matrix format (a two-dimensional matrix format) which is formed of four rows and 4 columns. The first row of the topmost level of the component table PT is a row illustrating the display item, "component name" is depicted in the first column of the leftmost side, and following in order hereon to the right side, "component data name" is depicted in the second column, "number" is depicted in the third column, and "circuit symbol" is depicted in the fourth column.

Component names such as "chip resistor 10 w", "IC", and the like are depicted, for example, in the second row onward of the first column of the component table PT. Even with the same chip resistor, if the resistance value is different, the component name and the component type will be different. Similarly, even with the same type of component, if the characteristic values or shapes are different, the component name and the component type will be different. The component data name such as "RM10R" and "IC225", for example, are depicted in the second column of the component table PT. The component data name is attached to the component data of each component which is stored separately from the component table PT. The component data includes design data, management data, and the like of the relevant component. The design data includes shape data which represents the external shape and dimensions, the arrangement of the connecting sections and the like, and characteristic data which represents characteristic values such as standard items, error level, and usage conditions of the relevant component.

The number of each component table which is to be mounted to a single circuit board is depicted in the third column of the component table PT. Circuit symbols such as "R1"**,**"R4", and "IC1", for example, are depicted in the fourth column of the component table PT. As "R1"**,** "R2", and "R3" are denoted in the second row of the fourth column, a plurality of circuit symbols may be denoted together in a single field. The creation device looks up the circuit symbol "R1" of the component identification information 31 in the fourth column of the component table PT, and focuses on the second row in which "R1" is included. The creation device identifies the component name of the relevant component from the first column of the second row as "chip resistor 10 w", and identifies the component data name of the relevant component from the second column as "RM10R". Various formats and display items other than those described above may be adopted, as suitable, for the format and display items of the component table PT.

In the template creation step S5, the creation device creates a component template image Tp1 based on the shape data of the relevant component (the chip resistor 10 w). Specifically, the creation device accesses the component data to which the component data name "RM10R" is attached, and reads the shape data of the relevant component. The creation device plots the numerical value information which represents a component external shape 51 of the shape data, and the numerical value information which represents the arrangement of connecting sections 52 and 53, and creates the component template image Tp1 which is exemplified in Fig. 7. Fig. 7 is a diagram exemplifying the component template image Tpl of the relevant component (the chip resistor 10 w). The component template image Tp1 is an image which represents the arrangement of the two connecting sections 52 and 53 on the component external shape 51 of the relevant component (the chip resistor 10 w) .

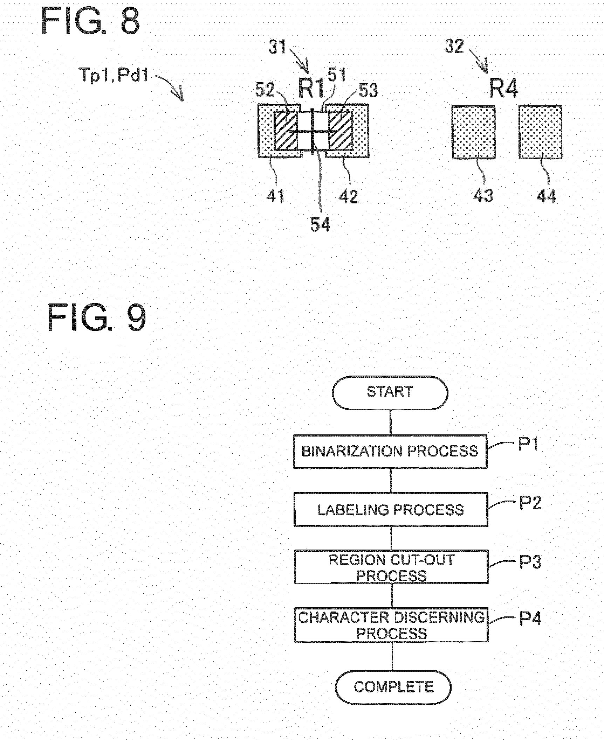

In the mounting coordinates calculation step S6, the creation device identifies the pads to which the two connecting sections 52 and 53 of the relevant component (the chip resistor 10 w) are to be connected by matching the component template image Tp1 to the pad arrangement image Pd1 in the vicinity of the component identification information 31 (the circuit symbol "R1"). At this time, the creation device preferentially matches the pads which are close to the component identification information 31. Fig. 8 is a diagram exemplifying matching results of matching the component template image Tp1 to the pad arrangement image Pd1. As depicted in the drawing, the two connecting sections 52 and 53 exactly overlap the pair of pads 41 and 42. Accordingly, the creation device is capable of identifying the pads 41 and 42 to which the two connecting sections 52 and 53 of the relevant component (the chip resistor 10 w) are connected.

A different pair of pads 43 and 44 also exactly overlap the two connecting sections 52 and 53; however, since the different pair of pads 43 and 44 are not in the vicinity of the component identification information 31 (the circuit symbol "R1"), the different pair of pads 43 and 44 are not relevant. Since the two connecting sections 52 and 53 of the relevant component (the chip resistor 10 w) do not have polarity, the matching results in which the component template image Tp1 is rotated 180° from Fig. 8, the connecting section 52 overlaps the pad 42, and the connecting section 53 overlaps the pad 41 are also valid. The creation device calculates the coordinate data of the center 54 of the component external shape 51 of the relevant component (the chip resistor 10 w) on the premise of the state illustrated in Fig. 8. Accordingly, the coordinate data of the relevant component (the chip resistor 10 w) which is identified by the first single item of component identification information 31 which is focused on is created. Furthermore, the creation device is capable of determining the rotational posture of the relevant component (the chip resistor 10 w) from the arrangement of the connecting sections 52 and 53.

In the completion determination step S7, before the coordinate data is created for all of the plurality of components, the creation device focuses of the new component identification information and returns to the data name identification step S4. In the board image Kb1 which is exemplified in Fig. 4, the two components which correspond to the two items of the component identification information 31 (the circuit symbol "R1"), and the component identification information 32 (the circuit symbol "R4") are all of the components. Therefore, in the first completion determination step S7, the creation device focuses on the new component identification information 32 instead of the component identification information 31 and returns to the data name identification step S4.

In the data name identification step S4 of the second time, the creation device looks up the circuit symbol "R4" of the component identification information 32 in the component table PT, focuses on the third row, and identifies that the component name of the relevant component is "chip resistor 50 w ", and the component data name of the relevant component is "RM50R" . In the template creation step S5 of the second time, the creation device accesses the component data to which the component data name "RM50R" is attached, and creates the component template image Tp1 from the shape data of the relevant component. The external shapes of the chip resistor 10 w and the chip resistor 50 w are of similar shape and size, and the component template images Tp1 of both match. Naturally, there are also many cases in which if the component data name is different, the component template image does not match.

In the mounting coordinates calculation step S6 of the second time, the creation device identifies the pads to which the two connecting sections of the relevant component (the chip resistor 50 w) are to be connected by matching the component template image Tp1 to the pad arrangement image Pd1 in the vicinity of the component identification information 32 (the circuit symbol "R4"). At this time, the creation device preferentially matches the pads which are close to the component identification information 32 (the circuit symbol "R4") while also excluding the pads 51 and 52 which are matched in the matching of another component from the matching targets . Accordingly, the creation device is capable of identifying the pads 43 and 44 to which the two connecting sections of the relevant component (the chip resistor 50 w) are connected. The creation device creates the coordinate data of the relevant component (the chip resistor 50 w) which is identified by the component identification information 32 and determines the rotational posture.

In the completion determination step S7, when the coordinate data is created for all of the plurality of components, the creation device completes the process operations of the automatic creation. In the board image which is exemplified in Fig. 4, since the coordinate data of two components is created at the point in time of the completion determination step S7 of the second time, the creation device completes the process operations of the automatic creation of the coordinate data.

Next, description will be given of a specific method of realizing improvements in the efficiency and the accuracy of the process operations of the component identification information acquisition step S2, the data name identification step S4, and the mounting coordinates calculation step S6. In the component identification information acquisition step S2, the creation device uses optical character recognition technology to read the character string information, which serves as the component identification information, from the board image. Fig. 9 is a diagram of a flowchart illustrating the process flow of the optical character recognition.

As illustrated in Fig. 9, the creation device first performs a binarization process P1 and displays the board image in the two colors of black and white. This is to clarify the high luminance information which is printed using a white ink, for example, and to remove the influence of the wiring pattern of an intermediate color, and the like. The creation device secondly performs a labeling process P2, and extracts clusters of high luminances which serve as character candidates in the binarized board image. A single cluster is a candidate for one character, and ordinarily, the creation device extracts a plurality of clusters. The creation device thirdly performs a region cut-out process P3, obtains a rectangle which circumscribes each cluster, and uses the rectangles as character candidate regions. The creation device fourthly performs a character discerning process P4, and discerns the character which is closest to the shape of the cluster in the character candidate region.

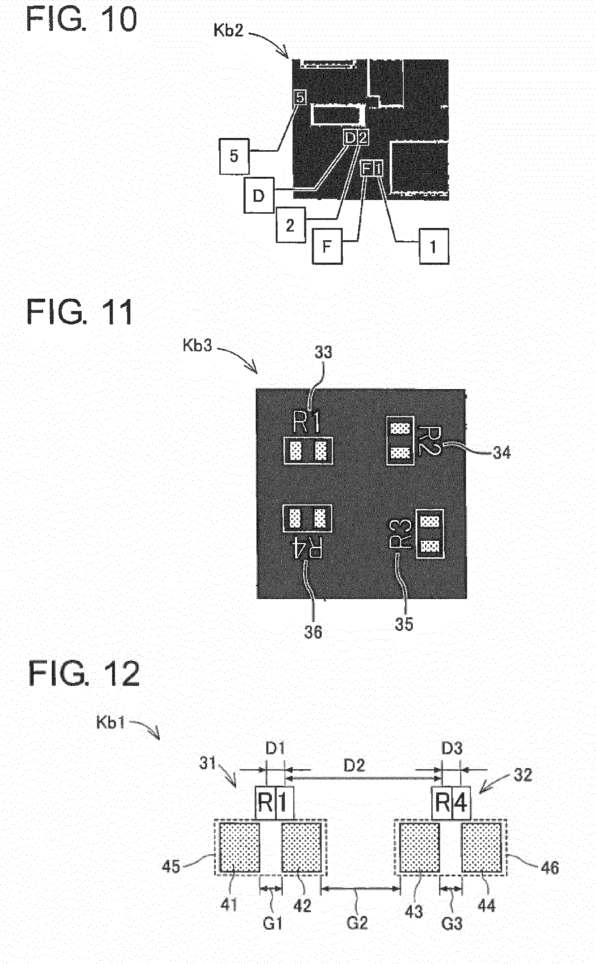

Fig. 10 is a diagram of a board image Kb2 exemplifying the process results of the process flow of the optical character recognition in the component identification information acquisition step S2. In the depicted example, five characters, "5", "D", "2", "F", and "1" are discerned in the binarized board image. Even if the portions of high luminance rectangular frame shapes are extracted as clusters, the portions are discarded due to the circumscribing rectangle being unsuitable, or due to no close character being discerned.

Furthermore, in the component identification information acquisition step S2, the creation device performs the reading in consideration of the rotational direction at which the component identification information is displayed. Fig. 11 is a diagram illustrating a case in which the rotational direction of the component identification information which is displayed on the circuit board changes at a pitch of 90°. In the example of Fig. 11, "R1" of component identification information 33 has a rotational angle of 0°, and it is possible to read "R1" as it is. In contrast, "R2", "R3", and "R4" of the component identification information 34 to 36 are displayed rotated by clockwise rotational directions of 90°, 180°, and 270°. Therefore, the creation device tests the character discerning for each of the four rotational directions in the character discerning process P4.

It is possible to apply the image processing library indicated next as the optical character recognition technology.
* MVTec GmbH "image processing software HALCON" (registered trademark)
* Media Drive Corporation "printed character document OCR library"
* ABBYY "ABBYY FINEREADER" (international registered trademark)

The creation device uses a threshold distance Dj to determine the delimitation of the character string information. For example, it is unclear how many items of component identification information the five characters which are read in Fig. 10 correspond to. Therefore, when the center-to-center distance between character string information which is divided into two falls within the threshold distance Dj, the creation device determines that the character string information is a single item of character string information, and when the center-to-center distance exceeds the threshold distance Dj, the creation device determines that the character string information is two separate items of character string information. Fig. 12 is a diagram illustrating a method of determining the delimitation of the character string information using the threshold distance Dj.

In the board image Kb1 which is exemplified in Fig. 4, first, four items of character information are separately identified. In other words, as illustrated in Fig. 12, "R" and "1" of the left side and "R" and "4" of the right side, which are lined up on a straight line, are identified separately. Since a center-to-center distance D1 between "R" and "1" of the left side falls within the threshold distance Dj, the creation device determines that "R" and "1" are a single item of character string information. Since a center-to-center distance D2 between "1" and "R" of the right side exceeds the threshold distance Dj, the creation device determines that "1" and "R" are a two separate items of character string information. Since a center-to-center distance D3 between "R" and "4" of the right side falls within the threshold distance Dj, the creation device determines that "R" and "4" are a single item of character string information. From the determination results described above, the creation device is capable of correctly specifying the two items of component identification information 31 and 32 which are exemplified in Fig. 4, and is capable of avoiding the erroneous component identification information "R1R4".

The creation device may use a pad threshold distance Gj to group a plurality of pads. For example, in Fig. 12, since a separation distance G1 between the pads 41 and 42, which are first and second from the left side of the pads lined up on a straight line, falls within the pad threshold distance Gj, the creation device determines that the pads 41 and 42 are the same group. Similarly, since a separation distance G3 between the pads 43 and 44, which are third and fourth from the left side, falls within the pad threshold distance Gj, the creation device determines that the pads 43 and 44 are the same group. Since a separation distance G2 between the pads 42 and 43, which are second and third from the left side, exceeds the pad threshold distance Gj, the creation device determines that the pads 42 and 43 are different groups. From the determination results described above, the creation device is capable of respectively grouping the pads 41 and 42, the two of which form a pair, into a first pad group 45, and the pads 43 and 44, the two of which form a pair, into a second pad group 46. At this time, the pad groups 45 and 46 correspond to a single component each. Accordingly, the matching process between the component template image Tp1 and the pad arrangement image Pd1 in the mounting coordinates calculation step S6 is greatly improved in efficiency.

The threshold distance Dj which is used in the determination of the delimitation of the character string information, and the pad threshold distance Gj which is used in the grouping of the pads may be set in advance in the creation device. When the type of the circuit board is changed, the threshold distance Dj and the pad threshold distance Gj may be set to be variable. Furthermore, with relation to the determination of the delimitation of the character string information, the determination may be performed using the separation distance between characters instead of the center-to-center distances D1 to D3.

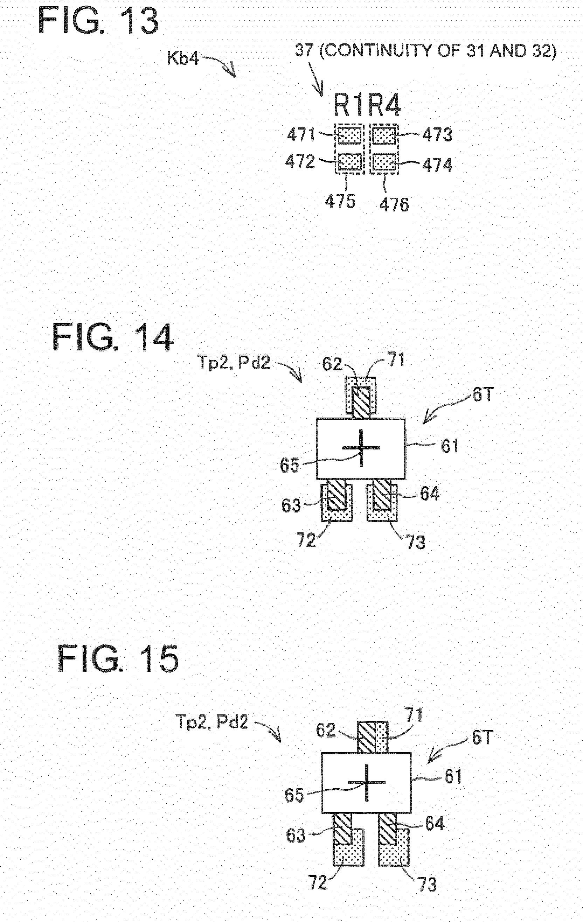

However, even if the delimitation of the character string information is determined using the threshold distance Dj, accurate component identification information may not necessarily be obtained. When the component arrangement on the circuit board becomes crowded, the plurality of items of component identification information inevitably become displayed in close proximity, and the case exemplified in Fig. 13 may arise. Fig. 13 is a diagram illustrating the identification method of a partial match which is performed on the component identification information which is formed of the character string information. In the example of Fig. 13, firstly, the erroneous circuit symbol "R1R4" is read from a board image Kb4 as component identification information 37. Meanwhile, a pair of pads 471 and 472 are favorably grouped into a third pad group 475, and a pair of pads 473 and 474 are favorably grouped into a fourth pad group 476.

In the data name identification step S4, the creation device uses the partial match identification method to specify the correct component identification information finally. For example, in a case in which a front partial match identification method is adopted, the creation device first looks up the first single character "R" of the component identification information 37 ("R1R4") in the fourth column of the component table PT, and confirms that "R" does not match the circuit symbol. Next, the creation device looks up the first two characters "R1" of the component identification information 37 ("R1R4") in the fourth column of the component table PT, and confirms that "R1" is present in the second row. Therefore, the creation device is capable of identifying the correct component identification information 31 (the circuit symbol "R1") finally by using front partial matching. The creation device divides the component identification information 37 ("R1R4") into two, and is capable of identifying the separate correct component identification information 32 (the circuit symbol "R4").

For example, in a case in which a rear partial matching identification method is adopted, the creation device first confirms that the last single character "4" of the component identification information 37 ("R1R4") does not match the circuit symbols, and that the final two characters "R4" are present in the third row. Therefore, the creation device is capable of identifying the correct component identification information 32 (the circuit symbol "R4") finally by using rear partial matching. The creation device divides the component identification information 37 ("R1R4") into two, and is capable of identifying the separate correct component identification information 31 (the circuit symbol "R1"). In such a partial match identification method, for example, when the character string information "R1R4IC1" is present, the creation device is capable of dividing the character string information "R1R4IC1" into the three correct circuit symbols "R1"**,** "R4", and "IC1" and identifying the circuit symbols.

Next, in the mounting coordinates calculation step S6, description will be given of the method of the smoothing process and the pattern matching process which are performed after the pads corresponding to each of the components are correctly identified. For example, when calculating the coordinate data of a transistor component 6T, the positional relationship illustrated in Fig. 14 is suitable, and the positional relationship illustrated in Fig. 15 is not suitable. Fig. 14 is a diagram schematically illustrating a case in which the positional relationship between a component template image Tp2 of the transistor component 6T and a pad arrangement image Pd2 is suitable. Fig. 15 is a diagram schematically illustrating a case in which the positional relationship between the component template image Tp2 of the transistor component 6T and the pad arrangement image Pd2 is not suitable.

In Fig. 14, the component template image Tp2 represents the arrangement of three rectangular terminals 62 to 64 on the component external shape 61 of the transistor component 6T, and is horizontally symmetrical. The single terminal 62 is disposed in the center of the top side of the rectangular component external shape 61, and the remaining two terminals 63 and 64 are disposed to be separated to the left and right on the bottom side of the component external shape 61. Meanwhile, the pad arrangement image Pd2 represents the arrangement of three rectangular pads 71 to 73 which correspond to the three terminals 62 to 64, and is horizontally symmetrical. Each of the pads 71 to 73 is formed a size larger than each of the terminals 62 to 64. Here, since the coordinate data of a center 65 of the transistor component 6T is suitable, the terminals 62 to 64 overlap the centers of the pads 71 to 73 in the left-right direction of the paper surface. The terminals 62 to 64 are not biased in the up-down direction of the paper surface, and overlap the pads 71 to 73 by approximately the same connection surface area.

In contrast, in Fig. 15, the coordinate data of the center 65 of the transistor component 6T is shifter to the top left in comparison to Fig. 14, and is not suitable. Therefore, although each of the terminals 62 to 64 overlaps the corresponding one of the pads 71 to 73, the terminals 62 to 64 deviate to the left direction of the paper surface. The connection surface area between the single terminal 62 and the pad 71 is great, and the connection surface areas between the remaining two terminals 63 and 64 and the pads 72 and 73 are small. In other words, the connection surface area between the terminals 62 to 64 are imbalanced. The deviation of the arrangement of the terminals 62 to 64 and the imbalanced connection surface areas are not preferable from the perspective of reliability. Therefore, in order to obtain the suitable positional relationship which is illustrated in Fig. 14, the creation device performs the smoothing process and the pattern matching process.

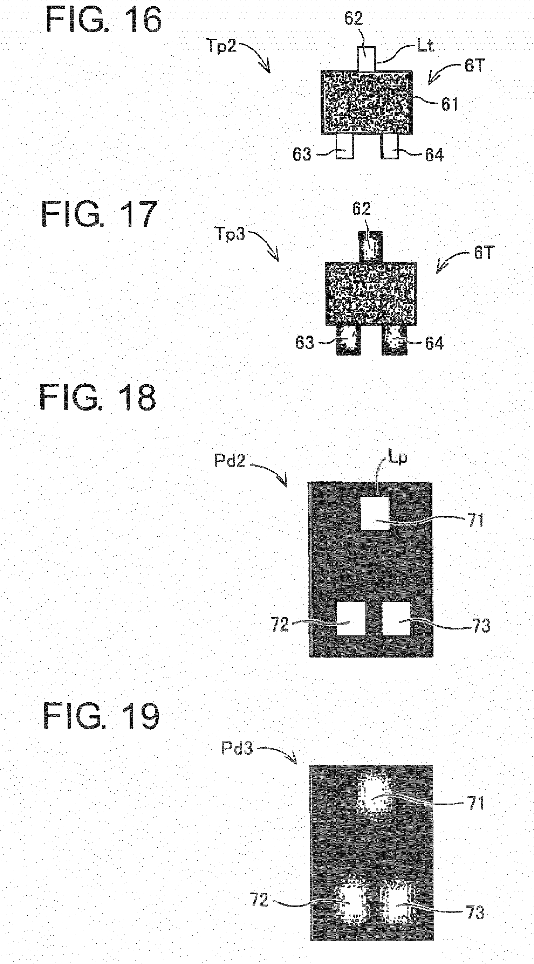

Fig. 16 is a diagram of the actual state of the component template image Tp2 of the transistor component 6T before carrying out a smoothing process. In the component template image Tp2 before the smoothing process, the inner portions of the terminals 62 to 64 are high luminance white, and an external line Lt is clearly depicted. The creation device carries out the smoothing process on the component template image Tp2 in which the luminance is gradually changed according to changes in the coordinates such that the inner portions of the terminals 62 to 64 become light and the outer portions become dark. Fig. 17 is a diagram of the actual state of a component template image Tp3 of the transistor component 6T after carrying out the smoothing process. In the component template image Tp3 after the smoothing process, the centers of the terminals 62 to 64 are bright, and become gradually darker as the external line Lt is approached, the external line Lt is depicted in a blurry manner, and the outer portion of the external line Lt is dark.

Fig. 18 is a diagram of the actual state of the pad arrangement image Pd2 before carrying out the smoothing process. In the pad arrangement image Pd2 before the smoothing process, the inner portions of the pads 71 to 73 are substantially a high luminance white, an external line Lp is depicted clearly, and the foundation of the circuit board is a low brightness black. The creation device carries out the smoothing process on a pad arrangement image Pd3 in which the luminance is gradually changed according to changes in the coordinates such that the inner portions of the pads 71 to 73 become light and the outer portions become dark. Fig. 19 is a diagram of the actual state of the pad arrangement image Pd3 after carrying out the smoothing process. In the pad arrangement image Pd3 after the smoothing process, the centers of the pads 71 to 73 are bright, and become gradually darker as the external line Lp is approached, the external line Lp is depicted in a blurry manner, and the outer portion of the external line Lp is dark.

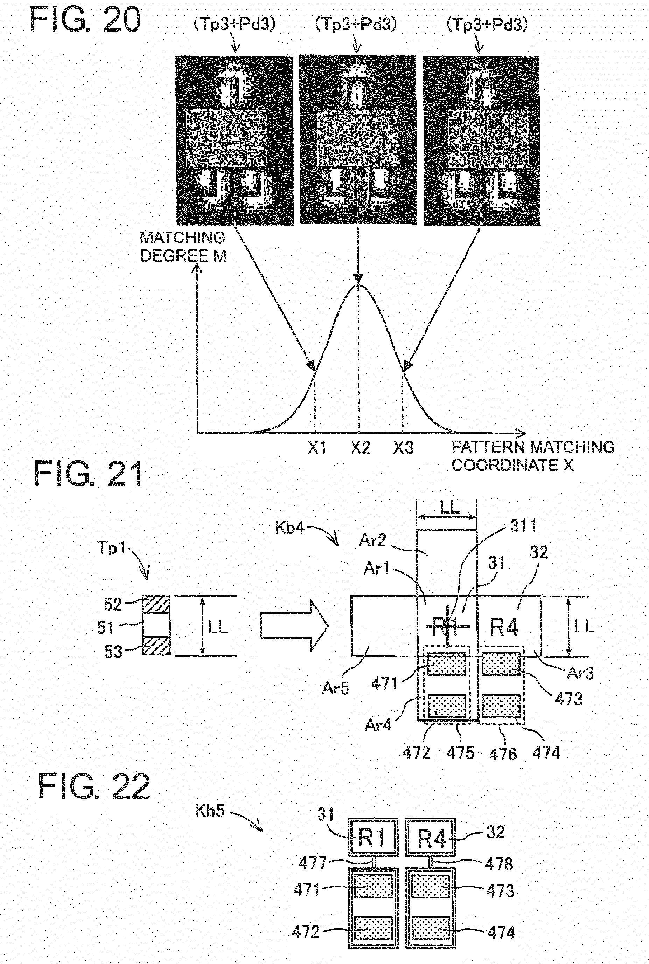

Next, the creation device performs the pattern matching process in which the component template image Tp3 and the pad arrangement image Pd3 after the smoothing process are caused to overlap while being moved relative to each other. Fig. 20 is a diagram illustrating the method of the pattern matching process. In the graph of the bottom level of Fig. 20, the horizontal axis represents a pattern matching coordinate X, and the vertical axis represents a matching degree M. The three types of image of the top level of Fig. 20 illustrate the positional relationship between the component template image Tp3 and the pad arrangement image Pd3 where the pattern matching coordinate X = X1, X2, and X3, respectively. The axes of symmetry of the pad arrangement images Pd3 which are horizontally symmetrical are depicted using dashed lines.

The creation device calculates the matching degree M while moving the component template image Tp3 in the left-right direction of the paper surface using the pad arrangement image Pd3 as a reference, that is, in the pattern matching coordinate X-direction. In the calculation of the matching degree M, the creation device obtains the difference in the luminance at the same coordinate position of the component template image Tp3 and the pad arrangement image Pd3, and adds the difference values in the image region together to obtain a difference sum value. The difference sum value becomes smaller when the light portions of the centers of the terminals 62 to 64 and the pads 71 to 73 overlap each other, and the dark portions near the external lines Lt and Lp overlap each other. Therefore, the smaller the difference sum value, the greater the matching degree M is defined.

Therefore, in the graph of the bottom level of Fig. 20, the matching degree M becomes great at the pattern matching coordinate X = X2. At this time, as illustrated in the image of the center of the top level of Fig. 20, the terminals 62 to 64 are disposed in the centers of the pads 71 to 73 in the X-direction, and the positional relationship is suitable. At the coordinates X1 and X3 at which the pattern matching coordinate X is shifted to the left and right in from the coordinate X2, the matching degree M is reduced. At this time, as illustrated in the images of the left side and the right side of the top level of Fig. 20, the terminals 62 to 64 are deviated from the centers of the pads 71 to 73 in the X-direction, and the positional relationship is not suitable.

The creation device calculates the matching degree M while moving the component template image Tp3 in the up-down direction of the paper surface using the pad arrangement image Pd3 as a reference, that is, in the Y-direction. The creation device calculates the coordinate data of the center 65 of the transistor component 6T based on a positional relationship in which the final matching degree M becomes greatest. Accordingly, the creation device is capable of obtaining the suitable positional relationship which is illustrated in Fig. 14.

Next, description will be given of the method of setting the mounting coordinate valid area when matching the component template image to the pad arrangement image. The object of setting the mounting coordinate valid area is to prevent the correspondence between the relevant component and the pad from becoming unclear, and to obtain an improvement in the efficiency of the matching process. For example, in the example of the board image Kb4 of Fig. 13, consideration is given to a case in which the component identification information 31 (the circuit symbol "R1") and the component identification information 32 (the circuit symbol "R4") are read correctly, and the third pad group 475 and the fourth pad group 476 are favorably grouped.

In this case, in the third pad group 475 and the fourth pad group 476, the disposition of the pairs of pads (471 and 472, and 473 and 474) is mutually the same, and both are positioned in the vicinity of the component identification information 31. Therefore, depending on the order of the matching, the concern is not eliminated that the creation device will erroneously determine that the fourth pad group 476 corresponds to the relevant component (the chip resistor 10 w) which is identified by the component identification information 31. In other words, there is a risk of an error in which the pads which correspond to the component identification information 31 are determined to be the fourth pad group 476 which is positioned to the diagonal lower right instead of the third pad group 475 which is positioned directly under.

However, the component identification information is generally disposed in an arrangement above, below, to the left, or to the right of the pad to which the relevant component is connected, and is not disposed in a diagonal position. Using this fact, the creation device sets the mounting coordinate valid area above, below, to the left, and to the right of the component identification information, and prevents the correspondence between the component identification information and the pads from becoming unclear. Fig. 21 is a diagram illustrating an example of the setting method of the mounting coordinate valid area.

When the creation device identifies the component data name of the relevant component which corresponds to the component identification information, the creation device reads the component long side dimension from the shape data. In the example of Fig. 21, the creation device reads a component long side dimension LL from the component data to which the component data name "RM10R" of the relevant component (the chip resistor 10 w) which corresponds to the component identification information 31 (the circuit symbol "R1") is attached. The component long side dimension LL is equal to the long side dimension of the component external shape 51 of the template image Tpl of the relevant component. Next, the creation device sets five areas, which are squares with a side length of the component long side dimension LL, as the mounting coordinate valid area in the vicinity of the component identification information 31 of the board image Kb4 . The area of five squares is formed of a center square area Ar1, and four peripheral square areas Ar2 to Ar5. The center square area Ar1 is disposed such that the center thereof overlaps the center 311 of the component identification information 31. The four peripheral square areas Ar2 to Ar5 are disposed to be in contact with each of the four sides of the center square area Ar1.

Subsequently, the creation device compares the component template image Tp1 to the pad arrangement image in the inner portions of the mounting coordinate valid areas Ar1 to Ar5. Therefore, the third pad group 475 (the pads 471 and 472) inside the peripheral square area Ar4 becomes a matching target, and the fourth pad group 476 (the pads 473 and 474) which is separated from the mounting coordinate valid areas Ar1 to Ar5 is excluded from the matching targets . Accordingly, the creation device is capable of reliably identifying third pad group 475 (the pads 471 and 472) to which the two connecting sections 52 and 53 of the relevant component (the chip resistor 10 w) are connected. Even in a case in which multiple pads are present on the actual circuit board, according to the method of setting the mounting coordinate valid area, it is possible to narrow down, in advance, the pads which become matching targets. Therefore, it is possible to improve the efficiency of the matching process in the mounting coordinates calculation step S6.

It is possible to display and clarify the correspondence between the component identification information and the pads to which the connecting sections are to be connected on the circuit board for at least a portion of the plurality of components. Fig. 22 is a diagram exemplifying the method of displaying the correspondence between the component identification information and the pads on the circuit board. In the example illustrated in a board image Kb5 of Fig. 22, the space between the component identification information 31 and the pair of pads 471 and 472 is displayed connected by a double line 477. Similarly, the space between the component identification information 32 and the pair of pads 473 and 474 is displayed connected by a double line 478.

According to this method, even if the creation device does not set the center square area Ar1 and the peripheral square areas Ar2 to Ar5, it is possible to confirm the connected display by the double lines 477 and 478 on the board image Kb5, and to clearly ascertain the correspondence between the component identification information and the pads. Therefore, it is possible to maximally improve the efficiency of the matching process in the mounting coordinates calculation step S6. The correspondence between the component identification information and the pads to which the connecting sections are to be connected may be displayed using a method other than the double lines 477 and 478.

The creation method of component mounting coordinates of the embodiment is a creation method of component mounting coordinates which automatically creates coordinate data of each mounting position of a plurality of components on a circuit board using the component table PT which associates component identification information with each item of which it is possible to identify each of the plurality of components to be mounted onto the circuit board, and component data names which are attached to component data of the plurality of components, in which the creation method acquires the pad arrangement image Pd1 which represents the component identification information 31 and 32 which is displayed on the circuit board, and arrangement of the pads 41 to 44 which are formed on the circuit board and to which connecting sections of the plurality of components are connected, and in which the creation method creates the component template image Tp1 which represents arrangements of the connecting sections 52 and 53 of a relevant component based on shape data of the relevant component which is included in the component data to which the component data name "RM10R" corresponding to the component identification information 31 (the circuit symbol "R1") is attached, and matches the component template image Tp1 to the pad arrangement image Pd1 in a vicinity of the relevant component identification information 31 to identify the pads 41 and 42 to which the connecting sections 52 and 53 of the relevant component are to be connected, and to further calculate the coordinate data of the relevant component on a premise of a state in which the connecting sections 52 and 53 of the relevant component are caused to overlap the pads 41 and 42 which are identified.

Accordingly, for the relevant component which is identified by the component identification information 31 (the circuit symbol "R1") which is displayed on the circuit board, the component template image Tp1 which represents the arrangement of the connecting sections 52 and 53 is created based on the shape data which is included in the component data to which the component data name "RM10R" corresponding to the component identification information 31 is attached, and the pads 41 and 42 are identified by matching the component template image Tp1 to the pad arrangement image Pd1 in the vicinity of the relevant component identification information 31. In other words, when identifying the pads to which the connecting sections of the relevant component are to be connected, not only is the pattern matching of the geometric arrangement performed, but the correspondence between the component identification information 31 (the circuit symbol "R1") and the component data name "RM10R" is also used. Therefore, even in a case in which a plurality of component types (the chip resistor 10 w and the chip resistor 50 w) of the same size and shape with different characteristic values are present and there is a concern that the correspondence between the components and the pads will be mistaken with only the pattern matching, the mistake no longer occurs due to the component identification information 31 which is displayed in the vicinity of the pads 41 and 42, and it is possible to accurately identify the pads which correspond to each component. In the matching between the component template image Tp1 and the pad arrangement image Pd1, the coordinate data of the relevant component is calculated on the premise of a state in which the connecting sections 52 and 53 of the relevant component are caused to overlap the pads 41 and 42 which are identified. Therefore, it is possible to reliably create the coordinate data of the suitable mounting coordinates at which it is possible to favorably connect the connecting sections 52 and 53 to the pads 41 and 42.

In the creation method of component mounting coordinates of the embodiment, the component identification information of the plurality of components and the pad arrangement image are read from a board impression image which is created from Gerber data which is used when producing the circuit board, or from a board captured image which is acquired by imaging the circuit board.

Accordingly, when the circuit board is close by, either of the board captured image and the board impression image may be adopted, and when the circuit board is not present, the board impression image is created. In a case in which the board impression image is adopted, the influence of allowable individual differences which arise from production and are present in a plurality of actual circuit boards is not received. In a case in which the board captured image is adopted, even if, hypothetically, there are differences between the Gerber data and the actual circuit board, it is possible to use an image which is matched to the actual circuit board.

In the creation method of component mounting coordinates of the embodiment, the component identification information includes character string information representing any one of the component name, an abbreviation of the component name, a circuit symbol corresponding uniquely to the component name, a type of the component, and a characteristic value of the component, and symbolic information representing a type of the component.

Accordingly, it is possible to adapt even if the display format of the component identification information changes depending on differences in the production maker of the circuit board, the designer of the circuit board, and the like, and applicable circuit boards are not limited.

In the creation method of component mounting coordinates of the embodiment, the component identification information includes the character string information, and when the center-to-center distance D1 or D3 between character string information which is divided into two falls within the threshold distance Dj, the character string information is determined to be a joined single item of character string information, and when the center-to-center distance D2 exceeds the threshold distance Dj, the character string information is determined to be two separate items of character string information.

Accordingly, even if a plurality of items of character string information "R", "1", "R", and "4" are lined up on a straight line, it is possible to correctly identify the component identification information 31 (the circuit symbol "R1") and the component identification information 32 (the circuit symbol "R4"), and it is possible to avoid "R1R4" which is mistaken component identification information 33. Therefore, the reading accuracy of the character string information is improved, and the identification accuracy of the component name is improved.

In the creation method of component mounting coordinates of the embodiment, a partial matching identification method is used in which when it is possible to identify the component name of the relevant component using only a portion ("R1" or "R4") of the character string information "R1R4", valid determination is performed.

Accordingly, even in a case in which the component arrangement on the circuit board becomes crowded, and the plurality of items of component identification information come into close proximity and are displayed as a single item of character string information "R1R4", it is possible to correctly identify the component identification information 31 (the circuit symbol "R1") and the component identification information 32 (the circuit symbol "R4") using front partial matching or rear partial matching. Therefore, the identification accuracy of the component name is further improved.

In the creation method of component mounting coordinates of the embodiment, after carrying out a smoothing process on the component template image Tp2 and the pad arrangement image Pd2, the component template image Tp3 and the pad arrangement image Pd3 are matched using a pattern matching process in which the component template image Tp3 and the pad arrangement image Pd3 are caused to overlap while being moved relatively, and coordinate data of the relevant component is calculated based on a positional relationship at which the matching degree M is greatest. Additionally, in the smoothing process, with regard to the component template image Tp2, brightness is gradually changed according to a change in coordinates such that inner portions of the connecting sections are bright and outer portions become dark, and with regard to the pad arrangement image Pd2, the luminance is gradually changed according to a change in coordinates such that inner portions of the pads are bright and outer portions become dark, and in the pattern matching process, the matching degree M is calculated using difference values of brightness at same coordinate positions in the component template image Tp3 and the pad arrangement image Pd3.

Accordingly, it is possible to obtain a suitable positional relationship in which the deviation of the terminals 62 to 64 from the pads 71 to 73, and the imbalance of the connection surface area between the terminals 62 to 64 and the pads 71 to 73 do not occur. Therefore, it is possible to obtain extremely high accuracy coordinate data of the mounting positions.

In the creation method of component mounting coordinates of the embodiment, a mounting coordinate valid area is set in a vicinity of the component identification information 31 which is displayed on the circuit board, and the component template image Tp1 is matched to the pad arrangement image in an inner portion of the mounting coordinate valid area. Additionally, the mounting coordinate valid area is five areas, which are squares with a side length of the component long side dimension LL of shape data of the relevant component which is included in the component data to which the component data name "RM10R" which corresponds to the component identification information 31 (the circuit symbol "R1") is attached, and the mounting coordinate valid area is formed of the center square area Ar1, in a center of which the component identification information 31 is disposed, and the four peripheral square areas Ar2 to Ar5 which are in contact with each of four sides of the center square area Ar1.

Accordingly, even in a case in which the component arrangement on the circuit board becomes crowded, and the plurality of pad groups 475 and 476 of the same arrangement are present in the vicinity of the component identification information 31, the fourth pad group 476 which is excluded from the mounting coordinate valid areas Ar1 to Ar5 are excluded from the matching targets. Accordingly, the creation device is capable of reliably identifying the third pad group 475 (the pads 471 and 472) to which the two connecting sections 52 and 53 of the relevant component (the chip resistor 10 w) which is identified by the component identification information 31 are connected. Even in a case in which multiple pads are present on the actual circuit board, when matching the component template image to the pad arrangement image, since it is possible to narrow down, in advance, the pads which become matching targets, it is possible to improve the efficiency of the matching process.

The creation method of component mounting coordinates of the embodiment includes a board information acquisition step (S1, S2, and S3) which acquires the component identification information 31 and 32 and the pad arrangement image Pd1 of each of the plurality of components, a data name identification step S4 which looks up a single item of the component identification information 31 (the circuit symbol "R1") in the component table PT and identifies a corresponding component data name "RM10R", a template creation step S5 which creates the component template image Tp1 based on shape data of the relevant component which is included in component data to which the corresponding component data name "RM10R" is attached, a mounting coordinates calculation step S6 which identifies the pads 41 and 42 to which the connecting sections 52 and 53 of the relevant component are to be connected by matching the component template image Tp1 to the pad arrangement image Pd1 in a vicinity of the relevant component identification information 31, and further calculates coordinate data of the relevant component, and a completion determination step S7 which returns to the data name identification step S4 focusing of a new item of the component identification information 32 before coordinate data of all of the plurality of components is created, and completes when coordinate data of all of the plurality of components is created.

Accordingly, the creation method of component mounting coordinates of the embodiment is performed mainly by a computer operating as the creation device of component mounting coordinates of the embodiment. Therefore, the coordinate data of the mounting positions is automatically created, and the labor of the operator is significantly reduced.

The creation method of component mounting coordinates of the embodiment may, for at least a portion of the plurality of components, display the correspondence between the component identification information 31 and 32 and the pads 471 to 474 to which the connecting sections are to be connected, on the circuit board using the double lines 477 and 478, for example.

Accordingly, even if the mounting coordinate valid areas Ar1 to Ar5 are not set, it is possible to clearly ascertain the correspondence between the component identification information 31 and 32 and the pads 471 to 474. It is possible to maximally improve the efficiency of the matching process which matches the component template image Tp1 to the pad arrangement image Pd1.

The creation device of the component mounting coordinates of the embodiment is a creation device of component mounting coordinates which automatically creates coordinate data of each mounting position of a plurality of components on a circuit board using the component table PT which associates component identification information with each item of which it is possible to identify each of the plurality of components to be mounted onto the circuit board, and component data names which are attached to component data of the plurality of components, the creation device including board information acquisition means for acquiring the pad arrangement image Pd1 which represents the component identification information 31 and 32 which is displayed on the circuit board, and arrangements of the pads 41 to 44 which are formed on the circuit board and to which connecting sections of the plurality of components are connected, and mounting coordinate calculation means for creating the component template image Tp1 which represents arrangements of the connecting sections 52 and 53 of a relevant component based on shape data of the relevant component which is included in the component data to which the component data name "RM10R" corresponding to the component identification information 31 "R1" is attached, and matching the component template image Tp1 to the pad arrangement image Pd1 in a vicinity of the relevant component identification information 31 to identify the pads 41 and 42 to which the connecting sections 52 and 53 of the relevant component are to be connected, and to further calculate the coordinate data of the relevant component on a premise of a state in which the connecting sections 52 and 53 of the relevant component are caused to overlap the pads 41 and 42 which are identified.

Accordingly, the creation device of component mounting coordinates of the embodiment is capable of performing the creation method of component mounting coordinates of the embodiment. The effect of the creation device of component mounting coordinates of the embodiment is similar to the effect of the creation method of component mounting coordinates of the embodiment

It is possible to apply various modifications and adaptations to the present invention other than those described in the embodiment.

### Reference Signs List

1T: transistor component, 11 to 13: terminal (connecting section), 1C: chip component, 15, 16: connecting section, 21 to 23, 25, 26: pad, 31 to 37: component identification information, 41 to 44: pad, 45: first pad group, 46: second pad group, 471 to 474: pad, 475: third pad group, 476: fourth pad group, 477, 478: double line, 51: component external shape, 52, 53: connecting section, 6T: transistor component, 61: component external shape, 62 to 64: terminal, 71 to 73: pad, Kb1 to Kb5: board image (board impression image or board captured image), PT: component table, Tp1, Tp2: component template image, Tp3: component template image after smoothing process, Pd1, Pd2: pad arrangement image, Pd3 : pad arrangement image after smoothing process, D1 to D3: center-to-center distance, G1 to G3: separation distance, LL: component long side dimension, Ar1: center square area, Ar2 to Ar5 : peripheral square area

## Claims

1. A creation method of component mounting coordinates which automatically creates coordinate data of each mounting position of a plurality of components on a circuit board using a component table which associates component identification information with each item of which it is possible to identify each of the plurality of components to be mounted onto the circuit board, and component data names which are attached to component data of the plurality of components, the method comprising:
acquiring (S3) a pad arrangement image which represents the component identification information which is displayed on the circuit board, and arrangements of pads which are formed on the circuit board and to which connecting sections of the plurality of components are connected; and
creating (S5) a component template image which represents arrangements of the connecting sections of a relevant component based on shape data of the relevant component which is included in the component data to which the component data name corresponding to the component identification information is attached, and matching the component template image to the pad arrangement image in a vicinity of relevant component identification information to identify (S6) the pads to which the connecting sections of the relevant component are to be connected, and to further calculate the coordinate data of the relevant component on a premise of a state in which the connecting sections of the relevant component are caused to overlap the pads which are identified,
wherein after carrying out a smoothing process on the component template image and the pad arrangement image, the component template image and the pad arrangement image are matched using a pattern matching process in which the component template image and the pad arrangement image are caused to overlap while being moved relatively, and coordinate data of the relevant component is calculated based on a positional relationship at which a matching degree is greatest,
wherein in the smoothing process, with regard to the component template image, brightness is gradually changed according to a change in coordinates such that inner portions of the connecting sections are bright and outer portions become dark, and with regard to the pad arrangement image, a luminance is gradually changed according to a change in coordinates such that inner portions of the pads are bright and outer portions become dark, and
wherein in the pattern matching process, the matching degree is calculated using difference values of brightness at same coordinate positions in the component template image and the pad arrangement image.

2. The creation method of component mounting coordinates according to Claim 1,
wherein the component identification information of the plurality of components and the pad arrangement image are read from a board impression image which is created from Gerber data which is used when producing the circuit board, or from a board captured image which is acquired by imaging the circuit board.

3. The creation method of component mounting coordinates according to Claim 1 or 2,
wherein the component identification information includes character string information representing any one of the component name, an abbreviation of the component name, a circuit symbol corresponding uniquely to the component name, a type of the component, and a characteristic value of the component, or symbolic information representing a type of the component.

4. The creation method of component mounting coordinates according to Claim 3,
wherein the component identification information includes the character string information, and
wherein when a center-to-center distance or a separation distance between character string information which is divided into two falls within a threshold distance, the character string information is determined to be a joined single item of character string information, and when the center-to-center distance or the separation distance exceeds the threshold distance, the character string information is determined to be two separate items of character string information.

5. The creation method of component mounting coordinates according to Claim 3 or 4,
wherein a partial matching identification method is used in which when it is possible to identify the component name of the relevant component using only a portion of the character string information, valid determination is performed.

6. The creation method of component mounting coordinates according to any one of Claims 1 to 5,
wherein a mounting coordinate valid area is set in a vicinity of the component identification information which is displayed on the circuit board, and the component template image is matched to the pad arrangement image in an inner portion of the mounting coordinate valid area.

7. The creation method of component mounting coordinates according to Claim 6,
wherein the mounting coordinate valid area is five areas, which are squares with a side length of a component long side dimension of shape data of the relevant component which is included in the component data to which the component data name which corresponds to the component identification information is attached, and
wherein the mounting coordinate valid area is formed of a center square area, in a center of which the component identification information is disposed, and four peripheral square areas which are in contact with each of four sides of the center square area.

8. The creation method of component mounting coordinates according to any one of Claims 1 to 7, the method comprising:
a board information acquisition step of acquiring the component identification information and the pad arrangement image of each of the plurality of components;
a data name identification step of looking up a single item of component identification information in the component table and identifying a corresponding component data name;
a template creation step of creating the component template image based on shape data of the relevant component which is included in component data to which the corresponding component data name is attached;
a mounting coordinates calculation step of identifying pads to which the connecting sections of the relevant component are to be connected by matching the component template image to the pad arrangement image in a vicinity of the relevant component identification information, and further calculating coordinate data of the relevant component; and
a completion determination step of returning to the data name identification step focusing of a new item of component identification information before coordinate data of all of the plurality of components is created, and completing when coordinate data of all of the plurality of components is created.

9. The creation method of component mounting coordinates according to any one of Claims 1 to 8,
wherein a correspondence between the component identification information and the pads to which the connecting sections are to be connected on the circuit board for at least a portion of the plurality of components is displayed.

10. A creation device of component mounting coordinates which automatically creates coordinate data of each mounting position of a plurality of components on a circuit board using a component table (PT) which associates component identification information (31, 32) with each item of which it is possible to identify each of the plurality of components to be mounted onto the circuit board, and component data names which are attached to component data of the plurality of components, the creation device comprising:
board information acquisition means for acquiring a pad arrangement image (Pd1) which represents the component identification information which is displayed on the circuit board, and arrangements of pads (41, 42, 43, 44) which are formed on the circuit board and to which connecting sections of the plurality of components are connected; and
mounting coordinate calculation means for creating a component template image (TP1) which represents arrangements of the connecting sections (52, 53) of a relevant component based on shape data of the relevant component which is included in the component data to which the component data name corresponding to the component identification information is attached, and matching the component template image to the pad arrangement image in a vicinity of relevant component identification information (31) to identify the pads to which the connecting sections of the relevant component are to be connected, and to further calculate the coordinate data (54) of the relevant component on a premise of a state in which the connecting sections of the relevant component are caused to overlap the pads which are identified,
wherein after carrying out a smoothing process on the component template image and the pad arrangement image, the component template image and the pad arrangement image are matched using a pattern matching process in which the component template image and the pad arrangement image are caused to overlap while being moved relatively, and coordinate data of the relevant component is calculated based on a positional relationship at which a matching degree is greatest,
wherein in the smoothing process, with regard to the component template image, brightness is gradually changed according to a change in coordinates such that inner portions of the connecting sections are bright and outer portions become dark, and with regard to the pad arrangement image, a luminance is gradually changed according to a change in coordinates such that inner portions of the pads are bright and outer portions become dark, and
wherein in the pattern matching process, the matching degree is calculated using difference values of brightness at same coordinate positions in the component template image and the pad arrangement image.

## Patentansprüche

1. Verfahren zum Erzeugen von Bauteilmontage-Koordinaten, mit dem automatisch Koordinaten-Daten jeder Montageposition einer Vielzahl von Bauteilen auf einer Leiterplatte unter Verwendung einer Bauteil-Tabelle erzeugt werden, die Bauteilidentifizierungs-Informationen, von denen jedes Element jedes der Vielzahl auf der Leiterplatte zu montierender Bauteile identifizieren kann, und Namen von Bauteil-Daten verknüpft, die an Bauteil-Daten der Vielzahl von Bauteilen angehängt sind, wobei das Verfahren umfasst:
Erfassen (S3) eines Anschlussstellenanordnungs-Bildes, das die Bauteilidentifizierungs-Informationen, die auf der Leiterplatte angezeigt werden, sowie Anordnungen von Anschlussstellen repräsentiert, die auf der Leiterplatte ausgebildet sind und mit denen Verbindungs-Teilabschnitte der Vielzahl von Bauteilen verbunden sind; sowie
Erzeugen (S5) eines Bauteilschablonen-Bildes, das Anordnungen der Verbindungs-Teilabschnitte eines betreffenden Bauteils auf Basis von Form-Daten des betreffenden Bauteils repräsentiert, die in den Bauteil-Daten enthalten sind, an die der Name der Bauteil-Daten angehängt ist, der den Bauteilidentifizierungs-Informationen entspricht, und Abgleichen des Bauteilschablonen-Bildes mit dem Anschlussstellenanordnungs-Bild in der Nähe der betreffenden Bauteilidentifizierungs-Informationen, um die Anschlussstellen zu identifizieren (S6), mit denen die Verbindungs-Teilabschnitte des betreffenden Bauteils zu verbinden sind, und des Weiteren die Koordinaten-Daten des betreffenden Bauteils unter Voraussetzung eines Zustandes zu berechnen, indem die Verbindungs-Teilabschnitte des betreffenden Bauteils veranlasst werden, die Anschlussstellen zu überlappen, die identifiziert werden,
wobei nach Ausführen eines Glättungs-Prozesses an dem Bauteilschablonen-Bild und dem Anschlussstellenanordnungs-Bild das Bauteilschablonen-Bild und das Anschlussstellenanordnungs-Bild unter Verwendung eines Musterabgleich-Prozesses abgeglichen werden, in dem veranlasst wird, dass das Bauteilschablonen-Bild und das Anschlussstellenanordnungs-Bild einander überlappen und dabei relativ zueinander bewegt werden, und Koordinaten-Daten des betreffenden Bauteils auf Basis einer Positionsbeziehung berechnet werden, bei der ein Übereinstimmungsgrad am größten ist,
bei dem Glättungs-Prozess hinsichtlich des Bauteilschablonen-Bildes die Helligkeit entsprechend einer Änderung von Koordinaten allmählich so geändert wird, dass innere Abschnitte der Verbindungs-Teilabschnitte hell sind und äußere Abschnitte dunkel werden, und hinsichtlich des Anschlussstellenanordnungs-Bildes eine Leuchtdichte entsprechend einer Änderung von Koordinaten allmählich so geändert wird, dass innere Abschnitte der Anschlussstellen hell sind und äußere Abschnitte dunkel werden, und
bei dem Musterabgleich-Prozess der Übereinstimmungsgrad unter Verwendung von Differenzwerten der Helligkeit an gleichen Koordinaten-Positionen in dem Bauteilschablonen-Bild und dem Anschlussstellenanordnungs-Bild berechnet wird.

2. Verfahren zum Erzeugen von Bauteilmontage-Koordinaten nach Anspruch 1,
wobei die Bauteilidentifizierungs-Informationen der Vielzahl von Bauteilen und das Anschlussstellenanordnungs-Bild aus einem Platten-Eindruckbild (board impression image), das anhand von Gerber-Daten erzeugt wird, die beim Herstellen der Leiterplatte genutzt werden, oder aus einem Platten-Aufnahmebild gelesen werden, das durch Erzeugen eines Bildes der Leiterplatte erfasst wird.

3. Verfahren zum Erzeugen von Bauteilmontage-Koordinaten nach Anspruch 1 oder 2, wobei die Bauteilidentifizierungs-Informationen Zeichenfolge-Informationen, die den Bauteil-Namen, eine Abkürzung des Bauteil-Namens, ein Schaltzeichen, das eindeutig dem Bauteil-Namen entspricht, einen Typ des Bauteils oder einen charakteristischen Wert des Bauteils repräsentiert, oder symbolische Informationen einschließen, die einen Typ des Bauteils repräsentieren.

4. Verfahren zum Erzeugen von Bauteilmontage-Koordinaten nach Anspruch 3,
wobei die Bauteilidentifizierungs-Informationen die Zeichenfolge-Informationen einschließen, und
wenn ein Mittenabstand oder ein Trennungsabstand zwischen Zeichenfolge-Informationen, die zweigeteilt sind, innerhalb eines Schwellen-Abstandes liegt, festgestellt wird, dass die Zeichenfolge-Informationen ein einzelnes Element verbundener Zeichenfolge-Informationen sind, und wenn der Mittenabstand oder der Trennungsabstand den Schwellen-Abstand überschreitet, festgestellt wird, dass die Zeichenfolge-Informationen zwei separate Elemente von Zeichenfolge-Informationen sind.

5. Verfahren zum Erzeugen von Bauteilmontage-Koordinaten nach Anspruch 3 oder 4, wobei ein Verfahren zur Identifizierung teilweiser Übereinstimmung eingesetzt wird, bei dem, wenn der Bauteil-Name des betreffenden Bauteils lediglich unter Verwendung eines Teils der Zeichenfolge-Informationen identifiziert werden kann, Gültigkeits-Feststellung durchgeführt wird.

6. Verfahren zum Erzeugen von Bauteilmontage-Koordinaten nach einem der Ansprüche 1 bis 5,
wobei ein Montagekoordinaten-Gültigkeitsbereich in der Nähe der Bauteilidentifizierungs-Informationen festgelegt wird, die auf der Leiterplatte angezeigt werden, und das Bauteilschablonen-Bild mit dem Anschlussstellenanordnungs-Bild in einem inneren Abschnitt des Montage-koordinaten-Gültigkeitsbereiches abgeglichen wird.

7. Verfahren zum Erzeugen von Bauteilmontage-Koordinaten nach Anspruch 6,
wobei der Montagekoordinaten-Gültigkeitsbereich aus fünf Bereichen besteht, die Quadrate mit einer Seitenlänge einer Bauteil-Längsseitenabmessung von Form-Daten des betreffenden Bauteils sind, die in den Bauteil-Daten eingeschlossen sind, an die der Name von Bauteil-Daten angehängt ist, der den Bauteilidentifizierungs-Informationen entspricht, und
der Montagekoordinaten-Gültigkeitsbereich aus einem mittleren quadratischen Bereich, in dessen Mitte die Bauteilidentifizierungs-Informationen angeordnet sind, sowie vier quadratischen Bereichen am Rand besteht, die in Kontakt mit jeder von vier Seiten des mittleren quadratischen Bereiches sind.

8. Verfahren zum Erzeugen von Bauteilmontage-Koordinaten nach einem der Ansprüche 1 bis 7, wobei das Verfahren umfasst:
einen Schritt zur Erfassung von Platten-Informationen, in dem die Bauteilidentifizierungs-Informationen und das Anschlussstellenanordnungs-Bild jedes der Vielzahl von Bauteilen erfasst werden;
einen Schritt zur Identifizierung eines Daten-Namens, in dem ein einzelnes Element von Bauteilidentifizierungs-Informationen in der Bauteil-Tabelle gesucht wird und ein entsprechender Name von Bauteil-Daten identifiziert wird;
einen Schritt zur Erzeugung einer Schablone, in dem das Bauteilschablonen-Bild auf Basis von Form-Daten des betreffenden Bauteils erzeugt wird, die in Bauteil-Daten eingeschlossen sind, an die der entsprechende Name der Bauteil-Daten angehängt ist;
einen Schritt zur Berechnung von Montage-Koordinaten, in dem Anschlussstellen identifiziert werden, mit denen Verbindungs-Teilabschnitte des betreffenden Bauteils zu verbinden sind, in dem das Bauteilschablonen-Bild mit dem Anschlussstellenanordnungs-Bild in der Nähe der betreffenden Bauteilidentifizierungs-Informationen abgeglichen wird und des Weiteren Koordinaten-Daten des betreffenden Bauteils berechnet werden;
einen Schritt zur Feststellung von Abschluss, in dem zu dem Schritt zurückgekehrt wird, und Konzentration auf ein neues Element von Bauteilidentifizierungs-Informationen stattfindet, bevor Koordinaten-Daten aller der Vielzahl von Bauteilen erzeugt werden, und Abschluss stattfindet, wenn Koordinaten-Daten aller der Vielzahl von Bauteilen erzeugt sind.

9. Verfahren zum Erzeugen von Bauteilmontage-Koordinaten nach einem der Ansprüche 1 bis 8,
wobei eine Entsprechung zwischen den Bauteilidentifizierungs-Informationen und den Anschlussstellen, mit denen die Verbindungs-Teilabschnitte an der Leiterplatte für wenigstens einen Teil der Vielzahl von Bauteilen zu verbinden sind, angezeigt wird.

10. Vorrichtung zum Erzeugen von Bauteilmontage-Koordinaten, (31, 32), die automatisch Koordinaten-Daten jeder Montageposition einer Vielzahl von Bauteilen auf einer Leiterplatte unter Verwendung einer Bauteil-Tabelle (PT) erzeugt, die Bauteilidentifizierungs-Informationen (31, 32), von denen jedes Element jedes der Vielzahl auf der Leiterplatte zu montierender Bauteile identifizieren kann, und Namen von Bauteil-Daten verknüpft, die an Bauteil-Daten der Vielzahl von Bauteilen angehängt sind, wobei das Vorrichtung zum Erzeugen umfasst:
eine Einrichtung zur Erfassung eines Anschlussstellenanordnungs-Bildes, mit der ein Anschlussstellenanordnungs-Bild (Pd1) erfasst wird, das die Bauteilidentifizierungs-Informationen, die auf der Leiterplatte angezeigt werden, sowie Anordnungen von Anschlussstellen (41, 42, 43, 44) repräsentiert, die auf der Leiterplatte ausgebildet sind und mit denen Verbindungs-Teilabschnitte der Vielzahl von Bauteilen verbunden sind; sowie
eine Einrichtung zur Berechnung von Montage-Koordinaten, mit der ein Bauteilschablonen-Bild (TP1) erzeugt wird, das Anordnungen der Verbindungs-Teilabschnitte (52, 53) eines betreffenden Bauteils auf Basis von Form-Daten des betreffenden Bauteils repräsentiert, die in den Bauteil-Daten enthalten sind, an die der Name der Bauteil-Daten angehängt ist, der den Bauteilidentifizierungs-Informationen entspricht, und das Bauteilschablonen-Bild mit dem Anschlussstellenanordnungs-Bild in der Nähe betreffender Bauteilidentifizierungs-Informationen (31) abgeglichen wird, um die Anschlussstellen zu identifizieren, mit denen die Verbindungs-Teilabschnitte des betreffenden Bauteils zu verbinden sind, und des Weiteren die Koordinaten-Daten (54) des betreffenden Bauteils unter Voraussetzung eines Zustandes zu berechnen, in dem die Verbindungs-Teilabschnitte des betreffenden Bauteils veranlasst werden, die Anschlussstellen zu überlappen, die identifiziert werden,
wobei nach Ausführen eines Glättungs-Prozesses an dem Bauteilschablonen-Bild und dem Anschlussstellenanordnungs-Bild das Bauteilschablonen-Bild und das Anschlussstellenanordnungs-Bild unter Verwendung eines Musterabgleich-Prozesses abgeglichen werden, in dem veranlasst wird, dass das Bauteilschablonen-Bild und das Anschlussstellenanordnungs-Bild einander überlappen und dabei relativ zueinander bewegt werden, und Koordinaten-Daten des betreffenden Bauteils auf Basis einer Positionsbeziehung berechnet werden, bei der ein Übereinstimmungsgrad am größten ist,
bei dem Glättungs-Prozess hinsichtlich des Bauteilschablonen-Bildes die Helligkeit entsprechend einer Änderung von Koordinaten allmählich so geändert wird, dass innere Abschnitte der Verbindungs-Teilabschnitte hell sind und äußere Abschnitte dunkel werden, und hinsichtlich des Anschlussstellenanordnungs-Bildes eine Leuchtdichte entsprechend einer Änderung von Koordinaten allmählich so geändert wird, dass innere Abschnitte der Anschlussstellen hell sind und äußere Abschnitte dunkel werden, und
bei dem Musterabgleich-Prozess der Übereinstimmungsgrad unter Verwendung von Differenzwerten der Helligkeit an gleichen Koordinaten-Positionen in dem Bauteilschablonen-Bild und dem Anschlussstellenanordnungs-Bild berechnet wird.

## Revendications

1. Procédé de création de coordonnées de montage de composants qui crée automatiquement des données de coordonnées de chaque position de montage d'une pluralité de composants sur une carte de circuit imprimé en utilisant une table de composants qui associe une information d'identification de composant à chaque élément pour lequel il est possible d'identifier chacun de la pluralité des composants à monter sur la carte de circuit imprimé, et des noms de données de composant qui sont rattachés à des données de composant de la pluralité de composants, le procédé comprenant :
l'acquisition (S3) d'une image d'agencement de pastilles qui représente l'information d'identification de composant qui est affichée sur la carte de circuit imprimé et des agencements de pastilles qui sont formées sur la carte de circuit imprimé et auxquelles des sections de connexion de la pluralité de composants sont connectées ; et
la création (S5) d'une image modèle de composant qui représente les agencements des sections de connexion d'un composant considéré sur la base de données de forme du composant considéré qui sont incluses dans les données de composant auxquelles le nom de données de composant correspondant à l'information d'identification de composant est rattaché, et la mise en correspondance de l'image de modèle de composant avec l'image d'agencement de pastilles au voisinage de l'information d'identification du composant considéré pour identifier (S6) les pastilles auxquelles les sections de connexion du composant considéré doivent être connectées, et pour, en outre, calculer les données de coordonnées du composant considéré en postulant un état dans lequel les sections de connexion du composant considéré sont amenées à chevaucher les pastilles qui sont identifiées,
dans lequel, après avoir procédé à un lissage de l'image modèle de composant et de l'image d'agencement de pastilles, l'image modèle de composant et l'image d'agencement de pastilles sont mises en correspondance grâce à un processus de mise en correspondance de motifs dans lequel l'image modèle de composant et l'image d'agencement de pastilles sont amenées à se chevaucher en étant soumises à un déplacement relatif, et des données de coordonnées du composant considéré sont calculées sur la base d'une relation de position à laquelle le degré de correspondance est le plus élevé,
dans lequel, dans le processus de lissage, concernant l'image modèle de composant, la luminosité est progressivement modifiée en fonction d'un changement de coordonnées de façon que les parties internes des sections de connexion soient lumineuses et que les parties externes deviennent foncées et, concernant l'image d'agencement de pastilles, la luminosité est progressivement modifiée en fonction d'un changement de coordonnées de façon que les parties internes des pastilles soient lumineuses et que les parties externes deviennent foncées, et
dans lequel, dans le processus de mise en correspondance de motifs, le degré de mise en correspondance est calculé en utilisant des valeurs de différence de luminosité à des positions ayant les mêmes coordonnées dans l'image modèle de composant et l'image d'agencement de pastilles.

2. Procédé de création de coordonnées de montage de composants selon la revendication 1,
dans lequel l'information d'identification de composant de la pluralité de composants et l'image d'agencement de pastille sont lues sur une image d'impression de carte qui est créée à partir de données Gerber qui sont utilisées lors de la fabrication de la carte de circuit imprimé, ou sur une image capturée de la carte acquise en faisant une image de la carte de circuit imprimé.

3. Procédé de création de coordonnées de montage de composants selon la revendication 1 ou 2,
dans lequel l'information d'identification de composant comprend de l'information sous forme de chaîne de caractères représentant le nom de composant ou une abréviation du nom de composant ou un symbole de circuit correspondant uniquement au nom de composant ou un type de composant ou une valeur caractéristique du composant, ou de l'information symbolique représentant un type de composant.

4. Procédé de création de coordonnées de montage de composants selon la revendication 3,
dans lequel l'information d'identification de composant comprend l'information sous forme de chaîne de caractères, et
dans lequel, lorsqu'une distance de centre à centre ou une distance de séparation au sein d'une information sous forme de chaîne de caractères qui est divisée en deux se trouve dans les limites d'une distance seuil, il est établi que l'information sous forme de chaîne de caractères est un élément unique relié d'information sous forme de chaîne de caractères et, lorsque la distance de centre à centre ou la distance de séparation dépasse la distance seuil, il est établi que l'information sous forme de chaîne de caractères consiste en deux éléments séparés d'information sous forme de chaîne de caractères.

5. Procédé de création de coordonnées de montage de composants selon la revendication 3 ou 4,
dans lequel un procédé d'identification par mise en correspondance partielle est utilisé, dans lequel, lorsqu'il est possible d'identifier le nom de composant du composant considéré en utilisant seulement une partie de l'information sous forme de chaîne de caractères, une détermination valide est effectuée.

6. Procédé de création de coordonnées de montage de composants selon l'une quelconque des revendications 1 à 5,
dans lequel une zone valide de coordonnées de montage est fixée au voisinage de l'information d'identification de composant qui est affichée sur la carte de circuit imprimé et l'image modèle de composant est mise en correspondance avec l'image d'agencement de pastilles dans une partie intérieure de la zone valide de coordonnées de montage.

7. Procédé de création de coordonnées de montage de composants selon la revendication 6,
dans lequel la zone valide de coordonnées de montage est constituée de cinq zones qui sont des carrés présentant une longueur de côté correspondant à une dimension d'un côté long de composant définie dans les données de forme du composant considéré qui sont incluses dans les données de composant auxquelles le nom de données de composant qui correspond à l'information d'identification de composant est rattaché, et
dans lequel la zone valide de coordonnées de montage est formée d'une zone carrée centrale, au centre de laquelle se trouve l'information d'identification de composant, et de quatre zones carrées périphériques qui sont en contact avec chacun des quatre côtés de la zone carrée centrale.

8. Procédé de création de coordonnées de montage de composants selon l'une quelconque des revendications 1 à 7, le procédé comprenant :
une étape d'acquisition d'information de carte consistant à acquérir l'information d'identification de composant et l'image d'agencement de pastilles de chacun de la pluralité des composants ;
une étape d'identification de nom de données consistant à chercher un élément unique d'information d'identification de composant dans la table de composants et à identifier un nom de données de composant correspondant ;
une étape de création de modèle consistant à créer l'image modèle de composant sur la base de données de forme du composant considéré qui sont incluses dans les données de composant auxquelles le nom de données de composant correspondant est rattaché ;
une étape de calcul de coordonnées de montage consistant à identifier les pastilles auxquelles les sections de connexion du composant considéré doivent être connectées en mettant en correspondance image modèle de composant et l'image d'agencement de pastilles au voisinage de l'information d'identification du composant considéré et, en outre, calculer des données de coordonnées du composant considéré ; et
une étape de détermination d'achèvement consistant à retourner à l'étape d'identification de nom de données, à cibler un nouvel élément d'information d'identification de composant avant de créer les données de coordonnées de tous les composants de la pluralité de composants, et à achever lorsque les données de coordonnées de tous les composants de la pluralité de composants sont créées.

9. Procédé de création de coordonnées de montage de composants selon l'une quelconque des revendications 1 à 8,
dans lequel une correspondance entre l'information d'identification de composant et les pastilles auxquelles les sections de connexion doivent être connectées sur la carte de circuit imprimé pour au moins une partie de la pluralité de composants est affichée.

10. Dispositif de création de coordonnées de montage de composants qui crée automatiquement des données de coordonnées de chaque position de montage d'une pluralité de composants sur une carte de circuit imprimé en utilisant une table de composants (soit PT, *component table*) qui associe une information d'identification de composant (31, 32) à chaque élément pour lequel il est possible d'identifier chaque composant de la pluralité des composants à monter sur la carte de circuit imprimé, et des noms de données de composant qui sont rattachés à des données de composant de la pluralité de composants, le dispositif de création comprenant :
un moyen d'acquisition d'information de carte permettant d'acquérir une image d'agencement de pastilles (Pd1) qui représente l'information d'identification de composant qui est affichée sur la carte de circuit imprimé et des agencements de pastilles (41, 42, 43, 44) qui sont formées sur la carte de circuit imprimé et auxquelles des sections de connexion de la pluralité de composants sont connectées ; et
un moyen de calcul de coordonnées de montage permettant de créer une image modèle de composant (TP1) qui représente les agencements des sections de connexion (52, 53) d'un composant considéré sur la base de données de forme du composant considéré qui sont incluses dans les données de composant auxquelles le nom de données de composant correspondant à l'information d'identification de composant est rattaché, et de mettre en correspondance l'image modèle de composant avec l'image d'agencement de pastilles au voisinage de l'information d'identification (31) du composant considéré pour identifier les pastilles auxquelles les sections de connexion du composant considéré doivent être connectées, et pour calculer en outre les données de coordonnées (54) du composant considéré en postulant un état dans lequel les sections de connexion du composant considéré sont amenées à chevaucher les pastilles qui sont identifiées,
dans lequel, après avoir procédé à un lissage de l'image modèle de composant et de l'image d'agencement de pastilles, l'image modèle de composant et l'image d'agencement de pastilles sont mises en correspondance grâce à un processus de mise en correspondance de motifs dans lequel l'image modèle de composant et l'image d'agencement de pastilles sont amenées à se chevaucher en étant soumises à un déplacement relatif, et des données de coordonnées du composant considéré sont calculées sur la base d'une relation de position à laquelle le degré de correspondance est le plus élevé,
dans lequel, dans le processus de lissage, concernant l'image modèle de composant, la luminosité est progressivement modifiée en fonction d'un changement de coordonnées de façon que les parties internes des sections de connexion soient lumineuses et que les parties externes deviennent foncées et, concernant l'image d'agencement de pastilles, la luminosité est progressivement modifiée en fonction d'un changement de coordonnées de façon que les parties internes des pastilles soient lumineuses et que les parties externes deviennent foncées, et
dans lequel, dans le processus de mise en correspondance de motifs, le degré de mise en correspondance est calculé en utilisant des valeurs de différence de luminosité à des positions ayant les mêmes coordonnées dans l'image modèle de composant et l'image d'agencement de pastilles.
